# EUROPEAN PATENT SPECIFICATION

(11) **EP 0 457 582 B1**
(45) Date of publication and mention of the grant of the patent: **27.03.1996**
(21) Application number: 91304396.4
(22) Date of filing: 16.05.1991
(51) Int. Cl.: G01R 19/165, G01R 1/44

(54) **Level detecting circuit**
Pegel-Erkennungsschaltung
Circuit pour détecter un niveau

(30) Priority: 17.05.1990 JP 128057/90
(43) Date of publication of application: 21.11.1991
(73) Proprietor: NEC CORPORATION, Tokyo (JP)
(72) Inventor: Nishijima, Kazunori, Minato-ku, Tokyo (JP)
(74) Representative: Jackson, David Spence

(56) References cited:
- EP-A- 0 084 722
- EP-A- 0 169 288
- US-A- 3 912 997

## Description

### Background of the Invention

The present invention relates to a transistor circuit and, more particularly, to a level detecting circuit.

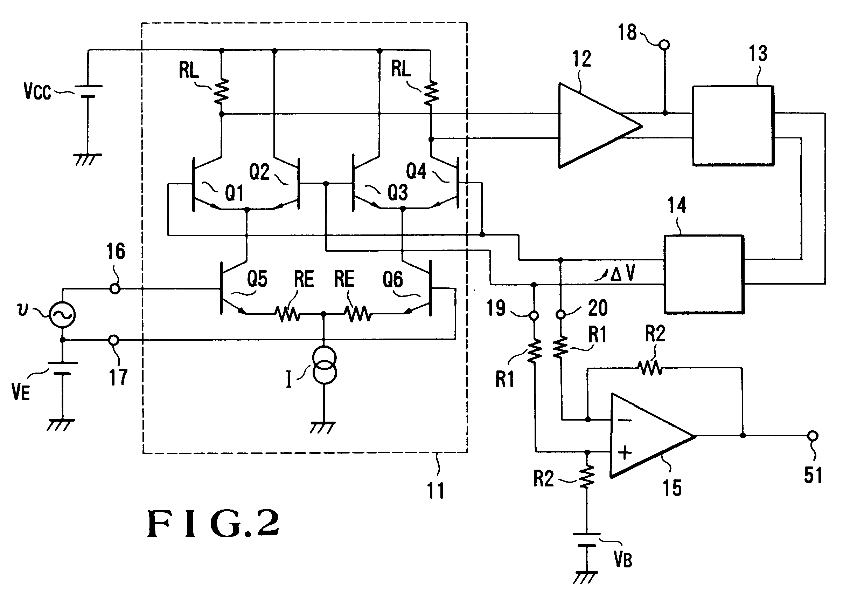

A level detecting circuit is generally designed to indicate the electric field strength of a signal (radio wave) in an FM/AM broadcast receiver, a satellite broadcast receiver, or the like. In general, an output from the level detecting circuit is input to a driving circuit of a signal level meter. As a means for obtaining a level detection output, a means for amplifying an RFAGC detection output from the front end portion of a tuner is available. Fig. 2 shows this means. A conventional level detecting circuit is denoted by reference numeral 15 in Fig. 2, which corresponds to an operational amplifier portion for amplifying a gain control voltage ΔV of a gain control amplifier 11 of an AGCAMP.

An operation of the circuit in Fig. 2 will be described below. A second AGCAMP is constituted by the gain control amplifier 11, a post-amplifier 12, an AGC detecting circuit 13, and a DC amplifier 14. An input signal to the AGCAMP is input to the base of a transistor Q5 and is amplified by the gain control amplifier 11. The input signal is amplified by the post-amplifier 12 and is subsequently input to the AGC detecting circuit 13 to be amplitude-detected. The AGC detection output is amplified by the DC amplifier 14 and is input to a differential electronic volume control constituted by transistors Q1 to Q4 to be subjected to AGC processing. A level at the start of AGC processing is set by the AGC detecting circuit 13. Assume that a gain of the gain control amplifier 11 is to be obtained. In this case, a mutual conductance gₘ of a differential circuit constituted by transistors Q5 and Q6 is represented by the following equation (v_{T} is the thermal voltage of the transistors):${\text{g}}_{\text{m}} \text{=} \frac{\text{1}}{\frac{{\text{v}}_{\text{T}}}{\text{I}} \text{+ 2} {\text{R}}_{\text{E}}}$ If a current I from a constant current source for the differential circuit is temperature-corrected by using a band gap regulator to establish${\text{I = v}}_{\text{T}} \text{/α}$ then, equation (1) is rewritten as follows:${\text{g}}_{\text{m}} \text{=} \frac{\text{1}}{\text{α + 2} {\text{R}}_{\text{E}}}$

Therefore, a collector current I_{c5}, of the transistor Q5 is given by the following equation, provided that an input signal to the AGCAMP is represented by vᵢ:${\text{I}}_{\text{C5}} \text{=} {\text{v}}_{\text{i}} {\text{g}}_{\text{m}} \text{+} \frac{\text{I}}{\text{2}}$ In a differential circuit constituted by the transistors Q1 and Q2, if the base voltages of the transistors Q1 and Q2 are represented by V_{B1} and V_{B2}, a voltage ΔV between the bases of the transistors Q1 and Q2 is given by$\text{Δ} \text{V} \text{=} {\text{V}}_{\text{B2}} \text{-} {\text{V}}_{\text{B1}}$ According to equations (5) and (4), a collector current I_{C1} of the transistor Q1 is given by${\text{I}}_{\text{C} \text{1}} \text{=} \frac{\text{e} {\text{}}^{\text{-} \frac{\text{Δ} \text{V}}{{\text{v}}_{\text{T}}}} {\text{I}}_{\text{C} \text{5}}}{\text{1 + e} {\text{}}^{\text{-} \frac{\text{Δ} \text{V}}{{\text{v}}_{\text{T}}}}} \text{=} \frac{{\text{I}}_{\text{C5}}}{\text{1 + e} {\text{}}^{\frac{\text{Δ} \text{V}}{{\text{v}}_{\text{T}}}}}$

A substitution of equation (5) into equation (6) yields${\text{I}}_{\text{C} \text{1}} \text{=} \frac{\text{1}}{\text{1 +} \text{e} {\text{}}^{\text{+} \frac{\text{Δ} \text{V}}{{\text{v}}_{\text{T}}}}} \text{(} {\text{v}}_{\text{i}} {\text{g}}_{\text{m}} \text{+} \frac{\text{I}}{\text{2}} \text{)} {\text{I}}_{\text{C} \text{2}} \text{=} \frac{{\text{g}}_{\text{m}}}{\text{1 +} \text{e} {\text{}}^{\text{+} \frac{\text{Δ} \text{V}}{{\text{v}}_{\text{T}}}}} {\text{v}}_{\text{i}} \text{+} \frac{\text{I}}{\text{2(1 +} \text{e} {\text{}}^{\text{+} \frac{\text{Δ} \text{V}}{{\text{v}}_{\text{t}}}} \text{)}}$

Therefore, a collector voltage V_{C1} of the transistor Q1 is represented by equation (8):${\text{V}}_{\text{C1}} \text{=} {\text{R}}_{\text{L}} {\text{I}}_{\text{C} \text{2}} \text{=} \frac{{\text{R}}_{\text{L}} {\text{g}}_{\text{m}}}{\text{1 +} \text{e} {\text{}}^{\text{+} \frac{\text{Δ} \text{V}}{{\text{v}}_{\text{T}}}}} {\text{v}}_{\text{i}} \text{+} \frac{{\text{R}}_{\text{L}} \text{I}}{\text{2(1 +} \text{e} {\text{}}^{\text{+} \frac{\text{Δ} \text{V}}{{\text{v}}_{\text{t}}}} \text{)}}$

An AC signal component v_{C1} of the collector voltage V_{C1} is represented by${\text{v}}_{\text{C1}} \text{=} \frac{{\text{R}}_{\text{L}} {\text{g}}_{\text{m}}}{\text{1 +} \text{e} {\text{}}^{\text{+} \frac{\text{Δ} \text{V}}{{\text{v}}_{\text{T}}}}} {\text{v}}_{\text{i}}$

That is, the input signal to the post-amplifier 12 becomes the AC signal component v_{C1}, and an output v₀ from the AGCAMP is given by the following equation, provided that the gain of the post-amplifier 12 is represented by A_{P0}:${\text{v}}_{\text{o}} {\text{= A}}_{\text{PO}} {\text{˙v}}_{\text{C1}} \text{=} \frac{{\text{A}}_{\text{PO}} {\text{R}}_{\text{L}} {\text{g}}_{\text{m}}}{\text{1 +} \text{e} {\text{}}^{\text{+} \frac{\text{Δ} \text{V}}{{\text{v}}_{\text{T}}}}} {\text{v}}_{\text{i}}$

If the AGCAMP is now performing an AGC operation, it can be assumed that an output from the AGCAMP is constant, and v₀ = V_{0C} (11). At this time, the relationship between the input signal and the value ΔV given by${\text{V}}_{\text{o}} \text{=} \frac{{\text{A}}_{\text{PO}} {\text{R}}_{\text{L}} {\text{g}}_{\text{m}}}{\text{1 +} \text{e} {\text{}}^{\text{+} \frac{\text{Δ} \text{V}}{{\text{v}}_{\text{T}}}}} {\text{v}}_{\text{i}}$

Equation (11) is solved with respect to ΔV as follows:$\text{1 +} \text{e} {\text{}}^{\text{+} \frac{\text{Δ} \text{V}}{{\text{v}}_{\text{T}}}} \text{=} \frac{{\text{v}}_{\text{1}}}{{\text{V}}_{\text{O}}} {\text{A}}_{\text{PO}} {\text{R}}_{\text{L}} {\text{g}}_{\text{m}} \text{e} {\text{}}^{\text{+} \frac{\text{Δ} \text{V}}{{\text{v}}_{\text{T}}}} \text{=} \frac{{\text{A}}_{\text{PO}} {\text{R}}_{\text{L}} {\text{g}}_{\text{m}}}{{\text{V}}_{\text{O}}} {\text{v}}_{\text{i}} \text{- 1} \frac{\text{Δ} \text{V}}{{\text{v}}_{\text{T}}} \text{= +log(} \frac{{\text{A}}_{\text{PO}} {\text{R}}_{\text{L}} {\text{g}}_{\text{m}}}{{\text{V}}_{\text{O}}} {\text{v}}_{\text{i}} \text{- 1)} \text{Δ} \text{V} \text{= +} {\text{v}}_{\text{T}} \text{log} \frac{{\text{A}}_{\text{PO}} {\text{R}}_{\text{L}} {\text{g}}_{\text{m}}}{{\text{V}}_{\text{O}}} {\text{v}}_{\text{i}} \text{- 1}$

Equation (12) indicates the relationship between the input signal level vᵢ and the difference in voltage between the transistors Q1 and Q2 in an AGCAMP operation. Referring to Fig. 2, the value ΔV corresponds to an AGC detection output obtained through the DC amplifier 14. In generally, the value ΔV is further amplified by an operational amplifier to obtain a level detection output. If the value ΔV is amplified by the operational amplifier 15 in Fig. 2, a level detection output L_{O} is given by${\text{L}}_{\text{O}} \text{=} \frac{{\text{R}}_{\text{2}}}{{\text{R}}_{\text{1}}} \text{Δ} \text{V} \text{+} {\text{V}}_{\text{B}} \text{=} \frac{{\text{R}}_{\text{2}}}{{\text{R}}_{\text{1}}} {\text{v}}_{\text{T}} \text{log(} \frac{{\text{A}}_{\text{PO}} {\text{R}}_{\text{L}} {\text{g}}_{\text{m}}}{{\text{V}}_{\text{O}}} {\text{v}}_{\text{i}} \text{- 1) +} {\text{V}}_{\text{B}}$

If equation (3) is substituted into equation (13), the level detection output L_{O} is represented by${\text{L}}_{\text{O}} \text{=} \frac{{\text{R}}_{\text{2}}}{{\text{R}}_{\text{1}}} {\text{v}}_{\text{T}} \text{log} \text{{} \frac{{\text{A}}_{\text{PO}} {\text{R}}_{\text{L}}}{{\text{V}}_{\text{O}} \left(\text{α + 2} {\text{R}}_{\text{E}}\right)} {\text{v}}_{\text{i}} \text{- 1}+} {\text{V}}_{\text{B}}$

In this conventional level detecting circuit, as indicated by equation (14):${\text{L}}_{\text{O}} \text{=} \frac{{\text{R}}_{\text{2}}}{{\text{R}}_{\text{1}}} {\text{v}}_{\text{T}} \text{log} \text{{} \frac{{\text{A}}_{\text{PO}} {\text{R}}_{\text{L}}}{{\text{V}}_{\text{o}} \left(\text{α + 2} {\text{R}}_{\text{E}}\right)} {\text{v}}_{\text{i}} \text{- 1}+} {\text{V}}_{\text{B}}$ since the level detection output L₀ includes the term of a thermal voltage, the value L₀ varies in relation to temperatures. For example, when a temperature t = -25°C, a level detection output L₁ is given by${\text{L}}_{\text{1}} \text{=} \frac{{\text{R}}_{\text{2}}}{{\text{R}}_{\text{1}}} \text{·} \frac{\text{k} \left(\text{273 - 25}\right)}{\text{q}} \text{·log{} \frac{{\text{A}}_{\text{PO}} {\text{R}}_{\text{L}}}{{\text{V}}_{\text{O}} \left(\text{α + 2} {\text{R}}_{\text{E}}\right)} {\text{v}}_{\text{i}} \text{- 1}+} {\text{V}}_{\text{B}}$ When the temperature t = 75°C, a level detection output L₂ is given by${\text{L}}_{\text{2}} \text{=} \frac{{\text{R}}_{\text{2}}}{{\text{R}}_{\text{1}}} \text{·} \frac{\text{k} \left(\text{273 + 75}\right)}{\text{q}} \text{·log{} \frac{{\text{A}}_{\text{PO}} {\text{R}}_{\text{L}}}{{\text{V}}_{\text{O}} \left(\text{α+2} {\text{R}}_{\text{E}}\right)} {\text{v}}_{\text{i}} \text{- 1}+} {\text{V}}_{\text{B}}$ (where A_{PO}, V_{O}, vᵢ, and V_{B} are constant with respect to temperatures.)

A ratio of L₂ to L₁ is given by$\frac{{\text{L}}_{\text{2}}}{{\text{L}}_{\text{1}}} \text{=} \frac{\text{273+75}}{\text{273-25}} \text{≒1.40}$

That is, the level detection output varies at 40% in the temperature range of -25°C to 75°C. The level detection output similarly varies with changes in the input signal vᵢ. Since the level detection output always varies with signal changes from a low-level input to a high-level input, some kind of temperature correction is required in a level meter driving circuit to which the level detection output is input. Otherwise, the level meter varies with temperature changes.

US 3912997 discloses a temperature compensation network for use with a force rebalance system. This temperature compensation network generates a corrective signal for modifying the output signal from a transducer. The bias/temperature characteristic of the transducer is first measured and then the resistance and temperature coefficients of the components to be used in the compensation network are evaluated. This is very different to a level detection system in which no corrective signal is generated.

### Summary of the Invention

It is an object of the present invention to provide a level detecting circuit which can suppress variations in output level with changes in temperatures.

It is another object of the present invention to provide a level detecting circuit which requires no temperature correction in a subsequent circuit to which a level detection output is input.

In order to achieve the above objects, according to the present invention, there is provided a level detecting circuit comprising an operational amplifier for receiving differential outputs from an AGC detecting circuit as inverting and non-inverting inputs, a first resistor connected between one differential output of said AGO detecting circuit and the inverting input of the operational amplifier, a second resistor connected between the other differential output of the AGC detecting circuit and the non-inverting input of said operational amplifier, a third resistor inserted in a negative feedback loop between an output of said operational amplifier and the inverting input of said operational amplifier, and a fourth resistor connected between a bias voltage and the non-inverting of input said operational amplifier, characterised by a fifth resistor connected in series with the third resistor, and a sixth resistor connected in series with the fourth resistor and in that each of said first, second, third, and fourth resistors have a first temperature coefficient and each of said fifth and sixth resistors have a second temperature coefficient, and the first and second temperature coefficients have substantially the same absolute value and opposite polarities.

### Brief Description of the Drawings

Fig. 1 is a block diagram showing an overall AGCAMP including an embodiment of the present invention;
Fig. 2 is a block diagram showing an overall AGCAMP including a conventional level detecting circuit; and
Fig. 3 is a block diagram showing an overall AGCAMP including another embodiment of the present invention.

### Description of the Preferred Embodiments

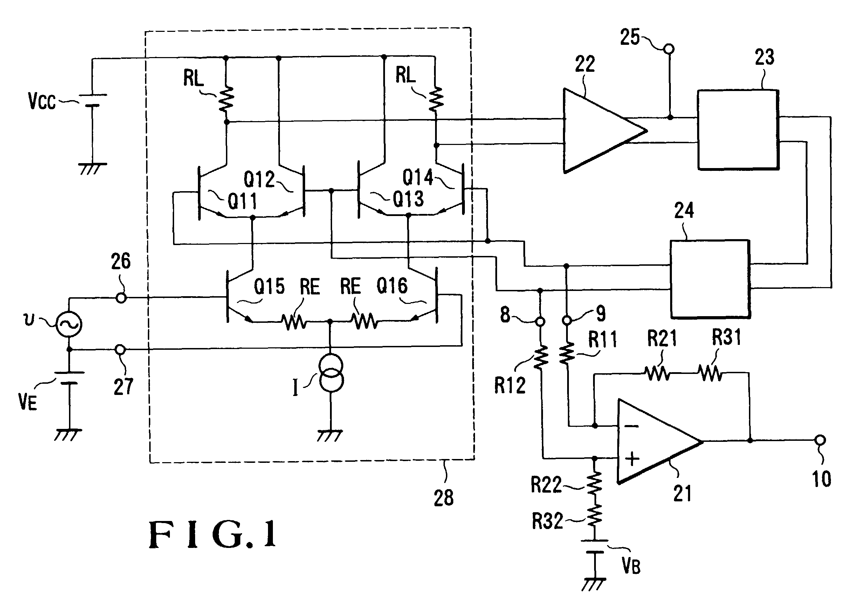

The present invention will be described below with reference to the accompanying drawings. Fig. 1 shows a level detecting circuit according to an embodiment of the present invention. Referring to Fig. 1, reference symbols R11, R12, R21, R22, R31, and R32 denote resistors. Reference numeral 21 denotes an operational amplifier; 22, a post-amplifier; 23, an AGC detecting circuit; 24, a DC amplifier; and 28, a gain control amplifier. AGC detection outputs (from the DC amplifier) input to input terminals 8 and 9 are amplified by the operational amplifier 21, and a level detection output is output from an output terminal 10. An operation of this circuit will be described below. The resistors R11, R12, R21, and R22 have the same temperature coefficient. Each of the resistors R31 and R32 has a temperature coefficient having the same absolute value as that of the temperature coefficient of each of the resistors R11, R12, R21, and R22 but having a polarity opposite thereto. If the absolute value of the temperature coefficient of each of the resistors R11, R12, R21, R22, R31, and R32 is represented by α, resistors R1 (R11, R12), R2 (R21, R22), and R3 (R31, R32) can be expressed as follows:$\text{R1} \text{=} {\text{R}}_{\text{10}} \text{(α} \text{t} \text{+ 1)}$$\text{R2} \text{=} {\text{R}}_{\text{20}} \text{(α} \text{t} \text{+ 1)}$$\text{R3} \text{=} {\text{R}}_{\text{30}} \text{(-α} \text{t} \text{+ 1)}$

Assume that the values of the resistors R2 and R3 are the same at the temperature t = 0, and R₂₀ = R₃₀. In this case,${\text{R}}_{\text{3}} \text{=} {\text{R}}_{\text{20}} \text{(-α} \text{t} \text{+ 1)}$

A gain G₀ of the operational amplifier 21 is then obtained as follows:${\text{G}}_{\text{o}} \text{=} \frac{\text{R2} \text{+} \text{R3}}{\text{R1}} \text{=} \frac{{\text{R}}_{\text{20}} \left(\text{α} \text{t} \text{+ 1}\right) \text{+} {\text{R}}_{\text{20}} \left(\text{-α} \text{t} \text{+ 1}\right)}{{\text{R}}_{\text{10}} \left(\text{α} \text{t} \text{+ 1}\right)} \text{=} \frac{\text{2} {\text{R}}_{\text{20}}}{{\text{R}}_{\text{10}} \left(\text{α} \text{t} \text{+ 1}\right)}$

According to equation (12), the AGC detection output ΔV obtained through the DC amplifier is given by$\text{Δ} \text{V} \text{=} {\text{v}}_{\text{T}} \text{log(} \frac{{\text{A}}_{\text{PO}} {\text{R}}_{\text{L}} {\text{g}}_{\text{m}}}{{\text{V}}_{\text{O}}} {\text{v}}_{\text{i}} \text{- 1)}$

Therefore, the level detection output L_{O1} is obtained by${\text{L}}_{\text{O1}} \text{=} {\text{G}}_{\text{O}} \text{Δ} \text{V} \text{+} {\text{V}}_{\text{B}} \text{=} \frac{\text{2} {\text{R}}_{\text{2O}}}{{\text{R}}_{\text{10}} \left(\text{α} \text{t} \text{+1}\right)} {\text{v}}_{\text{T}} \text{log(} \frac{{\text{A}}_{\text{PO}} {\text{R}}_{\text{L}} {\text{g}}_{\text{m}}}{{\text{V}}_{\text{O}}} {\text{v}}_{\text{i}} \text{- 1)} \text{=} \frac{\text{2} {\text{R}}_{\text{2O}}}{{\text{R}}_{\text{10}} \left(\text{αt + 1}\right)} \text{·} \frac{\text{k} \left(\text{t} \text{+273}\right)}{\text{q}} \text{·(} \frac{{\text{A}}_{\text{PO}} {\text{R}}_{\text{L}} {\text{g}}_{\text{m}}}{{\text{V}}_{\text{O}}} {\text{v}}_{\text{i}} \text{- 1)}$

As has been described above, according to the present invention, two resistors having the same resistance and the temperature coefficients with the same absolute value and opposite polarities are used as feedback resistors of the operational amplifier. Therefore, the level detection output L₀ is given by${\text{L}}_{\text{O}} \text{=} \frac{\text{2} {\text{R}}_{\text{20}}}{{\text{R}}_{\text{10}} \left(\text{αt + 1}\right)} \text{·} \frac{\text{k} \left(\text{t} \text{+ 273}\right)}{\text{q}} \text{log·(} \frac{{\text{A}}_{\text{PO}} {\text{R}}_{\text{L}} {\text{g}}_{\text{m}}}{{\text{V}}_{\text{O}}} {\text{v}}_{\text{i}} \text{- 1)}$

If the temperature coefficient of each of the resistors R1 and R2 is +2500 ppm, and the temperature coefficient of the resistor R3 is -2500 ppm, since α is the absolute value of a temperature coefficient,${\text{α = 1000 x 10}}^{\text{-6}} \text{= 0.0025}$

Therefore, the level detection output L_{O} is represented by${\text{L}}_{\text{O}} \text{=} \frac{\text{800} {\text{R}}_{\text{20}}}{{\text{R}}_{\text{10}} \left(\text{t+400}\right)} \text{·} \frac{\text{k} \left(\text{t} \text{+ 273}\right)}{\text{q}} \text{·log(} \frac{{\text{A}}_{\text{PO}} {\text{R}}_{\text{L}} {\text{g}}_{\text{m}}}{{\text{V}}_{\text{O}}} {\text{v}}_{\text{i}} \text{- 1)}$

The value gₘ of equation (3) is substituted into equation (27) to obtain${\text{L}}_{\text{O}} \text{=} \frac{\text{800} {\text{R}}_{\text{20}}}{{\text{R}}_{\text{10}} \left(\text{t + 500}\right)} \text{·} \frac{\text{k} \left(\text{t} \text{+ 273}\right)}{\text{q}} \text{·log{} \frac{{\text{A}}_{\text{PO}} {\text{R}}_{\text{L}}}{\left(\text{α + 2} {\text{R}}_{\text{E}}\right) {\text{V}}_{\text{o}}} {\text{v}}_{\text{i}} \text{- 1}}$

At t = -25°C, the level detection output L₁ is given by${\text{L}}_{\text{1}} \text{=} \frac{\text{2} {\text{R}}_{\text{20}}}{{\text{R}}_{\text{10}} \left(\text{-25 + 400}\right)} \text{·} \frac{\text{k} \left(\text{-25 + 273}\right)}{\text{q}} \text{·log{} \frac{{\text{A}}_{\text{PO}} {\text{R}}_{\text{L}}}{{\text{V}}_{\text{O}} \left(\text{α + 2} {\text{R}}_{\text{E}}\right)} {\text{v}}_{\text{i}} \text{- 1}}$

At t = 75°C, the level detection output L₂ is given by${\text{L}}_{\text{2}} \text{=} \frac{\text{2} {\text{R}}_{\text{20}}}{{\text{R}}_{\text{20}} \left(\text{75+400}\right)} \text{·} \frac{\text{k} \left(\text{75+273}\right)}{\text{q}} \text{·log{} \frac{{\text{A}}_{\text{PO}} {\text{R}}_{\text{L}}}{{\text{V}}_{\text{O}} \left(\text{α + 2} {\text{R}}_{\text{E}}\right)} {\text{v}}_{\text{i}} \text{-1}}$ (Note that the values A_{PO} and vᵢ do not vary with changes in temperature.)
A ratio of L₂ to L₁ is obtained as follows:$\frac{{\text{L}}_{\text{2}}}{{\text{L}}_{\text{1}}} \text{=} \frac{\frac{\text{75 + 273}}{\text{475}}}{\frac{\text{-25 + 273}}{\text{375}}} \text{≒1.11}$ That is, the variations in level detection output can be suppressed to be 11% through the temperature range of -25°C to +75°C. In comparison with the conventional circuit, the variations in level detection output with changes in temperature are reduced by about 30%.

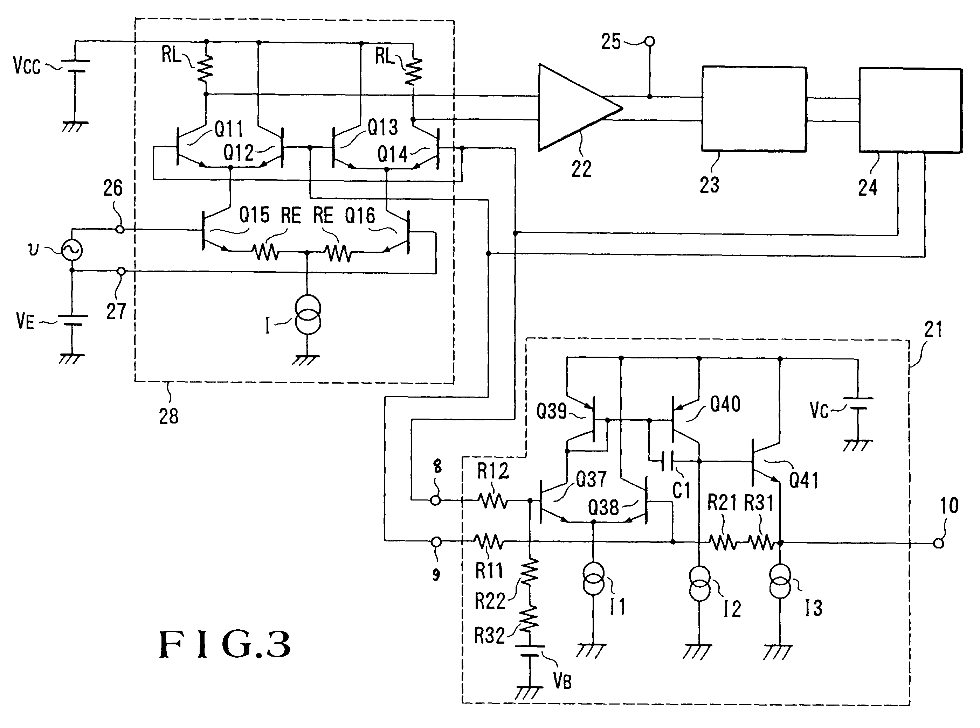

Fig. 3 shows a circuit according to the second embodiment of the present invention, which is a practical example of the level detection circuit 21 in Fig. 1. Referring to Fig. 3, resistors R12 and Rll are respectively connected between input terminals 8 and 9 and the bases of transistors Q37 and Q38. A series circuit consisting of resistors R22 and R32 is connected between the base of the transistor Q37 and a power supply VB. A series circuit consisting of resistors R21 and R31 is connected between the base of the transistor Q38 and the emitter of a transistor Q41. The emitter of the transistor Q37 is grounded through a constant current element I1, and the collector of the transistor Q37 is connected to the base and collector of a transistor Q39. The emitter and collector of the transistor Q38 are respectively connected to the emitter of the transistor Q37 and a power supply VC. The emitter of the transistor Q39 is connected to the power supply VC. The base of a transistor Q40 is connected to the base of the transistor Q39, and the collector of the transistor Q40 is grounded through a constant current element I2. The emitter of the transistor Q40 is connected to the power supply VC. A phase compensation capacitor C1 is connected between the base and collector of the transistor Q40. The base, collector, and emitter of the transistor Q41 are respectively connected to the collector of the transistor Q40, the power supply VC, and a constant current element I3. The node between the emitter of the transistor Q41 and the element I3 is connected to an output terminal 10.

In this arrangement, the same effect as described above can be obtained with the resistors R11, R12, R21, R22, R31, and R32 having the same relationship as that of the resistors in Fig. 1.

## Claims

1. A level detecting circuit comprising:
an operational amplifier (21) for receiving differential outputs from an AGC detecting circuit (23) as inverting and non-inverting inputs;
a first resistor (R11) connected between one differential output of said AGC detecting circuit (23) and the inverting input of the operational amplifier (21);
a second resistor (R12) connected between the other differential output of the AGC detecting circuit (23) and the non-inverting input of said operational amplifier (21);
a third resistor (R21) inserted in a negative feedback loop between an output of said operational amplifier (21) and the inverting input of said operational amplifier;
and a fourth resistor (R22) connected between a bias voltage and the non-inverting input of said operational amplifier (21);
characterised by a fifth resistor (R31) connected in series with the third resistor (R21), and a sixth resistor (R32) connected in series with the fourth resistor (R22) and in that each of said first, second, third, and fourth resistors (R11,R12,R21,R22) have a first temperature coefficient and each of said fifth and sixth resistors (R31,R32) have a second temperature coefficient, the first and second temperature coefficients having substantially the same absolute value and opposite polarities.

2. A circuit according to claim 1, wherein each of said first and second resistors (R11,R12) has a first resistance value and each of said third, fourth, fifth and sixth resistors (R21,R22,R31,R32) has a second resistance value.

3. A circuit according to claims 1 or 2, characterised in that said first resistor (R11) has identical characteristics to said second resistor (R12), said third resistor (R21) has identical characteristics to said fourth resistor (R22), and said fifth resistor (R31) has identical characteristics to said sixth resistor (R32).

## Patentansprüche

1. Pegel-Erkennungsschaltung mit:
einem Operationsverstärker (21) zum Aufnehmen von Differenzausgängen aus einer AGC-Erkennungsschaltung (23) als invertierende und nichtinvertierende Eingänge;
einem ersten Widerstand (R11), der zwischen einen Differenzausgang der AGC-Erkennungsschaltung (23) und den invertierenden Eingang des Operationsverstärkers (21) geschaltet ist;
einem zweiten Widerstand (R12), der zwischen den anderen Differenzausgang der AGC-Erkennungsschaltung (23) und den nichtinvertierenden Eingang des Operationsverstärkers (21) geschaltet ist;
einem dritten Widerstand (R21), der zwischen einem Ausgang des Operationsverstärkers (21) und den invertierenden Eingang des Operationsverstärkers in eine negative Rückkopplungsschleife eingesetzt ist;
und einem vierten Widerstand (R22), der zwischen eine Vorspannung und den nichtinvertierenden Eingang des Operationsverstärkers (21) geschaltet ist;
gekennzeichnet durch einen fünften Widerstand (R31), der mit dem dritten Widerstand (R21) in Reihe geschaltet ist, und einen sechsten Widerstand (R32), der mit dem vierten Widerstand (R22) in Reihe geschaltet ist, und dadurch, daß jeder der ersten, zweiten, dritten und vierten Widerstände (R11, R12, R21, R22) einen ersten Temperaturkoeffizienten besitzt und jeder der fünften und sechsten Widerstände (R31, R32) einen zweiten Temperaturkoeffizienten besitzt, wobei der erste und der zweite Temperaturkoeffizient im wesentlichen den gleichen absoluten Wert und entgegengesetzte Vorzeichen besitzen.

2. Schaltung nach Anspruch 1, bei der jeder der ersten und zweiten Widerstände (R11, R12) einen ersten Widerstandswert besitzt und jeder der dritten, vierten, fünften und sechsten Widerstände (R21, R22, R31, R32) einen zweiten Widerstandswert besitzt.

3. Schaltung nach Anspruch 1 oder 2, dadurch gekennzeichnet, daß der erste Widerstand (R11) mit dem zweiten Widerstand (R12) identische Kennwerte besitzt, der dritte Widerstand (R21) mit dem vierten Widerstand (R22) identische Kennwerte besitzt und der fünfte Widerstand (R31) mit dem sechsten Widerstand (R32) identische Kennwerte besitzt.

## Revendications

1. Circuit de détection de niveau comprenant:
un amplificateur opérationnel (21) pour recevoir des sorties différentielles d'un circuit de détection à CAG (23) en tant qu'entrées inverseuse et non-inverseuse;
une première résistance (R11) connectée entre une sortie différentielle dudit circuit de détection à CAG (23) et l'entrée inverseuse de l'amplificateur opérationnel (21);
une seconde résistance (R12) connectée entre l'autre sortie différentielle du circuit de détection à CAG (23) et l'entrée non inverseuse dudit amplificateur opérationnel (21);
une troisième résistance (R21) insérée dans une boucle à rétroaction négative entre une sortie dudit amplificateur opérationnel (21) et l'entrée inverseuse dudit amplificateur opérationnel;
et une quatrième résistance (R22) connectée entre une tension de polarisation et l'entrée non inverseuse dudit amplificateur opérationnel (21);
caractérisé par une cinquième résistance (R31) connectée en série avec la troisième résistance (R21), et une sixième résistance (R32) connectée en série avec la quatrième résistance (R22), et en ce que chacune desdites première, seconde, troisième et quatrième résistances (R11, R12, R21, R22) ont un premier coefficient de température et chacune desdites cinquième et sixième résistances (R31, R32) ont un second coefficient de température, les premier et second coefficients de température ayant des valeurs absolues sensiblement identiques et des polarités opposées.

2. Circuit selon la revendication 1, dans lequel chacune desdites première et seconde résistances (R11, R12) a une première valeur de résistance, et chacune desdites troisième, quatrième, cinquième et sixième résistances (R21, R22, R31, R32) a une seconde valeur de résistance.

3. Circuit selon la revendication 1 ou 2, caractérisé en ce que ladite première résistance (R11) a des caractéristiques identiques à ladite seconde résistance (R12), ladite troisième résistance (R21) a des caractéristiques identiques à ladite quatrième résistance (R22), et ladite cinquième résistance (R31) a des caractéristiques identiques à ladite sixième résistance (R32).
